# EUROPEAN PATENT APPLICATION

(11) **EP 2 278 711 A1**
(43) Date of publication of application: **26.01.2011**
(21) Application number: 09732826.4
(22) Date of filing: 16.04.2009
(51) Int. Cl.: H03K 3/012, H03K 3/64, H03K 3/72

(54) **CAPACITANCE/FREQUENCY CONVERTER WITH A VARIABLE CAPACITANCE AS AN OSCILLATOR POWER SUPPLY SOURCE**

(30) Priority: 16.04.2008 ES 200801085
(71) Applicant: Farsens, S.L., 20009 San Sebastián, Guipuzcoa (ES)
(72) Inventor: BERENGUER PÉREZ, Roc, E-20008 San Sebastián (Guipuzcoa) (ES); VAZ SERRANO, Alexander, E-20010 San Sebastián (Guipuzcoa) (ES); UBARRETXENA BELANDIA, Aritz, E-20003 San Sebastián (Guipuzcoa) (ES); AYERDI OLAIZOLA, Isabel, E-20003 Donostia (Guipuzcoa) (ES); SEVILLANO BERASATEGUI, Juan Francisco, E-20014 San Sebastián (Guipuzcoa) (ES); GARCÍA-ALONSO MONTOYA, Andrés, E-20018 San Sebastián (Guipuzcoa) (ES)
(74) Representative: ABG Patentes, S.L.
(86) International application number: PCT/ES2009/000200
(87) International publication number: WO 2009/127757

(57) **Abstract**

The invention relates to a capacity-frequency converter with variable capacity as a power source for the oscillator comprising a variable capacity device (300) which supplies the oscillator (400) providing a pulse train (Vₚᵤₗₛₑ) to a counter (500) from which a binary output (tₒᵤₜₚᵤₜ) is obtained which depends on the discharge time of the capacitor of the variable capacity device (300) and on the voltage (V_{cap}) between the capacity terminals.

## Description

### Field of the Art

The present invention is related to circuits for capacitive transducers, proposing a low consumption capacity-frequency converter circuit providing a digital output.

### State of the Art

There is currently a clear tendency to minimize the power consumption of the integrated circuits, this trend originating in the wide growth of those applications in which the power consumption is crucial, such as for example in wireless sensors, RFID transponders (Radio Frequency identification) provided with a sensor, etc.

Circuits consisting of a battery with a very limited power availability (active circuits), circuits which collect and temporarily store the power of a radiating source for their correct operation (passive circuits) and circuits having a very limited alternative power source as occurs in the field of thermoelectrics or photoelectrics can be distinguished in such applications, being desirable in all of them to reach minimum power consumption levels, such that for those having a battery their life is extended and for those that do not have batteries, their communication distance increases.

In addition, in most current applications, and especially in those relating to capacitive transducers, it is preferable to have the output information of the circuit in digital (rather than analog) form, even though it involves a certain increase in the total consumption of the circuit.

In this sense, most of the capacitive transducers have an analog-digital converter circuit. However these converters considerably increase the consumption of the circuit, therefore the current trend is the implementation of digital output capacitive transducers which do not incorporate analog-digital converters.

### Object of the Invention

According to the invention a capacity-frequency converter circuit, for capacitive transducers, is proposed with which a low consumption is obtained, allowing application in RFID transponders or with a generally in wireless sensors.

The circuit object of the invention consists of a voltage regulator providing a stable voltage to the circuit against the supply voltage; a switch, which switches the origin of the power supply between the voltage regulator and a variable capacity device; a variable capacity device, which stores the power from the voltage regulator and therefore supplying an oscillator; a ring-shaped oscillator, which generates a pulse train the number of which depends on the magnitude to be measured; a counter, which counts the number of pulses delivered by the oscillator; a comparator, which compares the voltage stored in the variable capacity device with a reference voltage for determining when the switch switches; and a control logic, for coordinating the operations of the previous modules.

The switch depending on a control signal (t_{active}) providing the control logic, short circuits the points of the voltage from the voltage regulator (V_{reg}) and of the voltage from the variable capacity device (V_{cap}), such that when said signal is active, the switch will disconnect the voltage regulator of the variable capacity device, in turn activating the ring-shaped oscillator which will take the power of said variable capacity device.

The comparator in turn will compare the voltage from the variable capacity device (V_{cap}) with a reference value (K*V_{ref}), activating, when it reaches this value, a signal (t_{comp}) and consequently deactivating the control signal (t_{active}), the oscillator and the counter. This causes the switch to short circuit the points (V_{reg}) and (V_{cap}) and the variable capacity device to start to be loaded with the voltage (V_{reg}) provided by the voltage regulator.

The variable capacity device, for example a capacitive transducer, the capacity of which varies with the variable to be measured, stores the power from the voltage regulator when the oscillator is disconnected, whereas when it starts to oscillate, the device will provide the stored power to the oscillator as a power supply, such that the more capacity the device has the greater the time (tₘₑₐₛ) will be that the oscillator will be connected and the greater the number of pulses will be which will be obtained at its output (Vₚᵤₗₛₑ). The number of pulses at the output (tₒᵤₜₚᵤₜ) of the counter will thus unequivocally and with great sensitivity depend on the magnitude to be measured.

The ring-shaped oscillator, invariable to the temperature variations, consists of an odd number of negation logic gates, a circuit protector against variations of the supply voltage, an activation/deactivation circuit, a current source with a high power supply rejection ratio (PSRR) and a start-up circuit to establish a stable operation point of the current source.

Finally, the control logic block takes two input signals, which are the measurement start signal with the transducer (tₛₜₐᵣₜ) and the signal from the comparator (t_{comp}), generating the control signal (t_{active}), these signals being necessary for the correct coordination of the different modules of the circuit.

### Description of the Drawings

Figure 1 shows a general block diagram of the capacity-frequency converter circuit object of the invention.
Figure 2 shows a circuit scheme of the architecture of the ring-shaped oscillator.
Figure 3 shows a current source with a high PSRR.
Figure 4 shows graphs of the operation of the oscillator according to the supply voltage of the oscillator (V_{cap}).

### Detailed Description of the Invention

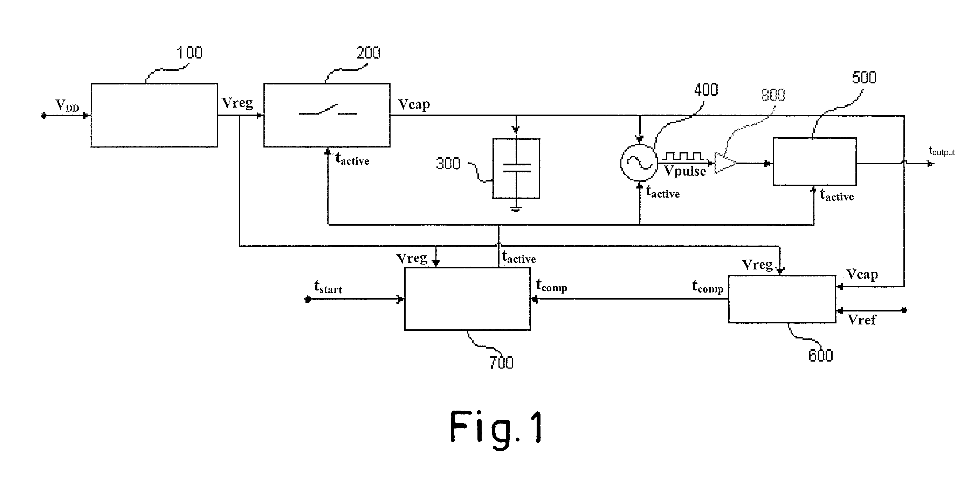

The object of the invention relates to a capacity-frequency converter circuit, with low consumption and digital output, for capacitive transducers, which, as shown in the scheme of Figure 1, comprises a voltage regulator (100), a switch (200), one or more variable capacity devices (300), a ring-shaped oscillator (400), a counter (500), a comparator (600) and a control logic block (700).

The circuit is connected to a power source which provides it with a supply voltage (V_{DD}) through the voltage regulator (100), delivering a stable supply voltage (V_{reg}) to the switch (200), the comparator (600) and the control logic block (700).

The switch (200) receives a control signal (t_{active}), generated by the control logic block (700) depending on its input signals (tₛₜₐᵣₜ), measurement start signal with the transducer (300), and (t_{comp}), a signal from the comparator (600). This signal will command the state of the switch (200), such that when the signal (t_{active}) is active the switch (200) will disconnect the voltage regulator (100) from the rest of the circuit, which will be supplied with the power (V_{cap}) stored in the variable capacity device (capacitive transducer) (300), and when it is inactive, the circuit will be connected to the voltage regulator (100) the variable capacity device (300) being loaded with the voltage (V_{reg}).

The ring-shaped oscillator (400) and the counter (500) will in turn be inactive when this control signal (t_{active}) is deactivated such that the circuit saves in power consumption.

The variable capacity device or capacitive transducer (300), as has been previously indicated, stores the voltage (V_{reg}) from the voltage regulator (100), providing by means of this capacity a supply voltage (V_{cap}) to the ring-shaped oscillator when the switch is disconnected from the voltage regulator and the oscillator starts to operate.

Given that capacitive transducers (300) vary their capacity depending on the magnitude to be measured, in the proposed circuit, a value of stored power (V_{cap}) which will supply the oscillator during a time (tₘₑₐₛ) will correspond to each value of said capacity. The greater the capacity of the transducer (300) is the greater the operation time of the oscillator (tₘₑₐₛ) will be and the greater the number of pulses will be forming the pulse train at the output of the oscillator (Vₚᵤₗₛₑ).

The ring-shaped oscillator (400) shown in Figure 2, is made up of a pulse generator formed by an odd number of negation logic gates generating the oscillation, these logic gates being able to be a number of simple inverters (430), formed by NMOS and PMOS transistors and a NAND gate (420), to allow activating the oscillator depending on the signal (t_{active}); an activation/deactivation circuit for activating/deactivating the supply voltage for the components of the oscillator according to the control signal (t_{active}); a current source (412) with a high power supply rejection ratio (PSRR) for supplying the logic gates generating the oscillation; a start-up circuit (411) for providing the stable operation point of the current source (412).

The cascode configured current source, the scheme of which is shown in Figure 3, determines a start-up circuit (411), preventing the current from reaching a degeneration point which would cause a circuit malfunction, and a current source circuit (412) with a high PSRR. This current source, supplying the logic gates of the oscillator (400), must vary with respect to the temperature of the logic gates, such that the current source-oscillator (400) assembly is invariable to the temperature.

The counter (500), in charge of counting the number of pulses generated by the oscillator (400) during a time (tₘₑₐₛ), which is equivalent to the time that the signal (t_{active}) is activated, the number of pulses will be obtained at its output in a binary digital word (tₒᵤₜₚᵤₜ). The number of bits of this binary output (tₒᵤₜₚᵤₜ) will depend on the range and on the resolution with which the measurement is to be carried out.

The comparator (600), comparing the voltage (V_{cap}) with a reference voltage (V_{ref}), will activate its output signal (t_{comp}) if the voltage (V_{cap}) is less than a value (K*V_{ref}). When this signal (t_{comp}) is activated, the control logic block (700) will deactivate the control signal (t_{active}) and therefore the oscillator (400) and the counter will be turned off and the switch (200) will be closed, the variable capacity being loaded and returning to the initial state of the transducer (300).

Figure 4 shows graphs of the performance of the signals (V_{cap}) and (Vₚᵤₗₛₑ) for different values of the capacity (C₁, C₂, C₃) of the capacitive transducer (300).

As observed, when the signal (tₛₜₐᵣₜ) is activated, the switch (200) disconnects the capacity of the voltage regulator (100) and the oscillator (400) starts to oscillate, taking the power (V_{cap}) stored in the capacity of the capacitive transducer (300). For this reason, the capacity is unloaded until reaching a voltage value (K*V_{ref}), when this occurs the comparator (600) activates the signal (t_{comp}) turning off the oscillator (300) and makes the switch (200) connect the capacity of the capacitive transducer (300) to the voltage regulator (100) again.

As can be seen in the figure, the larger the capacity is the longer it will take to be unloaded, since it has more power stored, and therefore the counter (500) will count the pulses from the oscillator (400) during more time (tₘₑₐₛ₃>tₘₑₐₛ₁), whereby at the output (tₒᵤₜₚᵤₜ) of the counter (500) a number of pulses depending on the capacity of the capacitive transducer (300) will be obtained, and consequently depending on the magnitude to be measured.

Finally, in a preferred embodiment of the invention, the incorporation of a memory buffer (800) is envisaged connected to the output of the oscillator (400), providing the necessary gain so that the signal is more easily detectable by the counter (500).

## Claims

1. A capacity-frequency converter with variable capacity as a power source for the oscillator having a low power consumption and providing a digital output, **characterized in that** it consists of a voltage regulator (100), a switch (200), one or more variable capacity devices (300) with the magnitude to be measured, a ring-shaped oscillator (400), a counter (500), a comparator (600) and a control logic (700), such that the variable capacity device (300) supplies the oscillator (400) when the switch (200) is disconnected, which in its output provides the counter (500) with a pulse train (Vₚᵤₗₛₑ), providing the counter (500) a binary output (tₒᵤₜₚᵤₜ) depending on both the discharge time (tₘₑₐₛ) of the capacitor of the variable capacity device (300) and on the voltage (V_{cap}) between the capacity terminals and therefore the magnitude to be measured.

2. The capacity-frequency converter with variable capacity as a power source for the oscillator according to claim 1, **characterized in that** the variable capacity device (300) is a capacitive transducer.

3. The capacity-frequency converter with variable capacity as a power source for the oscillator according to claim 1, **characterized in that** the ring-shaped oscillator (400) is formed by:
- An activation/deactivation circuit for activating and deactivating the supply voltage for the rest of the components integrating the oscillator (400) according to a control signal (t_{active}).
- A pulse generator formed by an odd number of negation logic gates.
- A current source (412) with a high PSRR used for supplying the ring-shaped oscillator (400).
- A start-up circuit (411) for the current source (412) supplying the ring-shaped oscillator (400).
- One or several MEMS capacitors supplying the oscillator (400), the capacity values of which vary with the magnitude to be measured.

4. The capacity-frequency converter with variable capacity as a power source for the oscillator according to claim 1, **characterized in that** in a preferred embodiment of the invention, the incorporation of a memory buffer (800) is envisaged connected to the output of the oscillator (400) providing the necessary gain so that the signal has an invariable amplitude and is more easily detected by the counter (500).
